(19) Europäisches Patentamt
European Patent Office
Office européen des brevets

(11) **EP 4 291 005 A1**

(12) **EUROPEAN PATENT APPLICATION**

(43) Date of publication:
**13.12.2023 Bulletin 2023/50**

(21) Application number: **23174309.7**

(22) Date of filing: **19.05.2023**

(51) International Patent Classification (IPC):
**H10K 59/38** (2023.01)     **H10K 59/35** (2023.01)
**H10K 59/121** (2023.01)

(52) Cooperative Patent Classification (CPC):
**H10K 59/38; H10K 59/121; H10K 59/35;**
H10K 59/8791

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.06.2022   CN 202210648650**

(71) Applicant: **Innolux Corporation
Jhunan Town, Miaoli County 35053 (TW)**

(72) Inventors:
• **LI, Wen-Tse**
  **35053 Jhunan Town, Miaoli County (TW)**
• **LIAO, Shih-Fu**
  **35053 Jhunan Town, Miaoli County (TW)**
• **YAO, I-An**
  **35053 Jhunan Town, Miaoli County (TW)**

(74) Representative: **Becker, Eberhard
Becker Kurig & Partner
Patentanwälte mbB
Bavariastraße 7
80336 München (DE)**

(54) **DISPLAY DEVICE**

(57)     A display device (1) includes a substrate (10), a plurality of light-emitting units (11), a plurality of color filter units (12) and a protecting layer (13). The plurality of color filter units (12) are disposed on the plurality of light-emitting units (11) and include a first color filter unit (12-1). The first color filter unit (12-1) is overlapped with a first light-emitting unit (11-1) of the plurality of light-emitting units (11). The protecting layer (13) is arranged on the plurality of color filter units (12). The display device (1) has a maximum light-emitting angle 82, the protecting layer (13) has a refractive index n1, the first color filter unit (12-1) has a width WCF along a first direction (D1), a light-emitting layer of the first light-emitting unit (11-1) has a width WL along the first direction (D1), and the first color filter unit (12-1) has a thickness HCF, a distance H is formed between the first light-emitting unit (11-1) and the first color filter unit (12-1).

FIG. 1

**Description**

BACKGROUND

Field of the Disclosure

The present disclosure relates to an electronic device, in particular to a display device.

Description of Related Art

In a highly illuminated environment, an ambient light reflected by a display device will cause the brightness of dark state to increase, which in turn results in low contrast of the display device.

SUMMARY OF THE DISCLOSURE

The present disclosure provides a display device, which helps to improve the contrast of the display device.
According to an embodiment of the present disclosure, a display device includes a substrate, a plurality of light-emitting units, a plurality of color filter units and a protecting layer. The plurality of light-emitting units are arranged on the substrate, and a pitch P is formed between two of the adjacent light-emitting units. The plurality of color filter units are disposed on the plurality of light-emitting units and include a first color filter unit. The first color filter unit is overlapped with a first light-emitting unit of the plurality of light-emitting units. The protecting layer is arranged on the plurality of color filter units. The display device has a maximum light-emitting angle θ2, the protecting layer has a refractive index n1, the first color filter unit has a width WCF along a first direction, a light-emitting layer of the first light-emitting unit has a width WL along the first direction, and the first color filter unit has a thickness HCF, a distance H is formed between the first light-emitting unit and the first color filter unit. The display device satisfies:

$$2 * \tan\{\sin^{-1}[\frac{\sin(\theta2)}{n1}]\} * (HCF + H) + WL \leq WCF \leq \frac{1}{2} * P .$$

In order to make the above-mentioned features and advantages of the present disclosure more clear and comprehensible, the following specific embodiments are described in detail in conjunction with the accompanying drawings.

BRIEF DESCRIPTION OF THE DRAWINGS

The accompanying drawings are included to provide a further understanding of the disclosure, and are incorporated in and constitute a part of this specification. The drawings illustrate of the disclosure and, together with the description, serve to explain the principles of the disclosure.

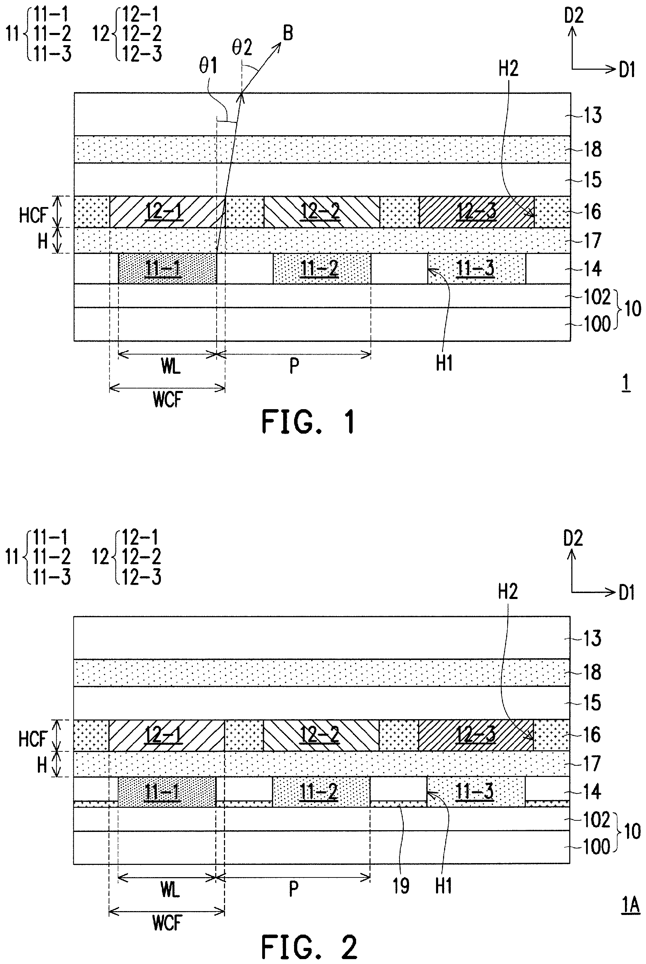

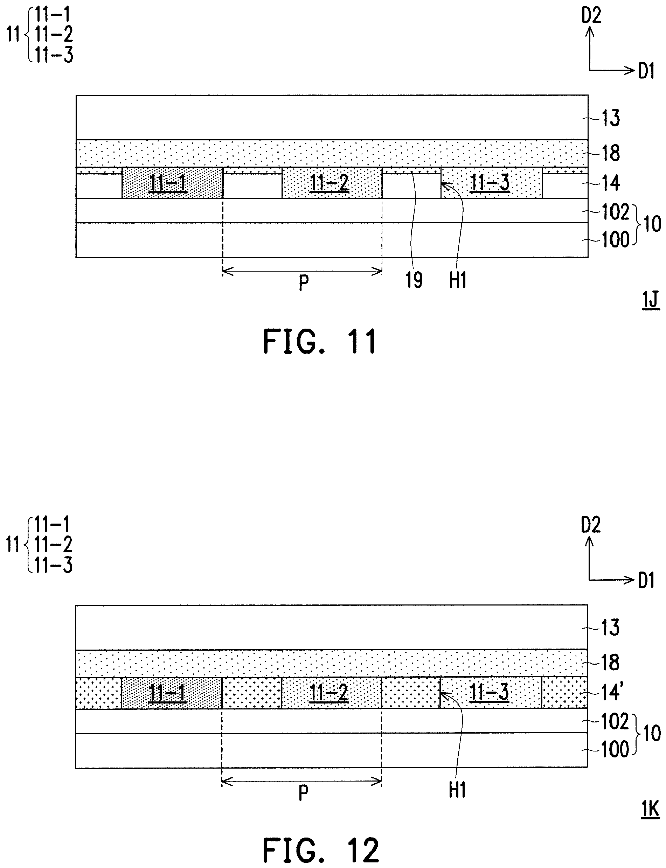

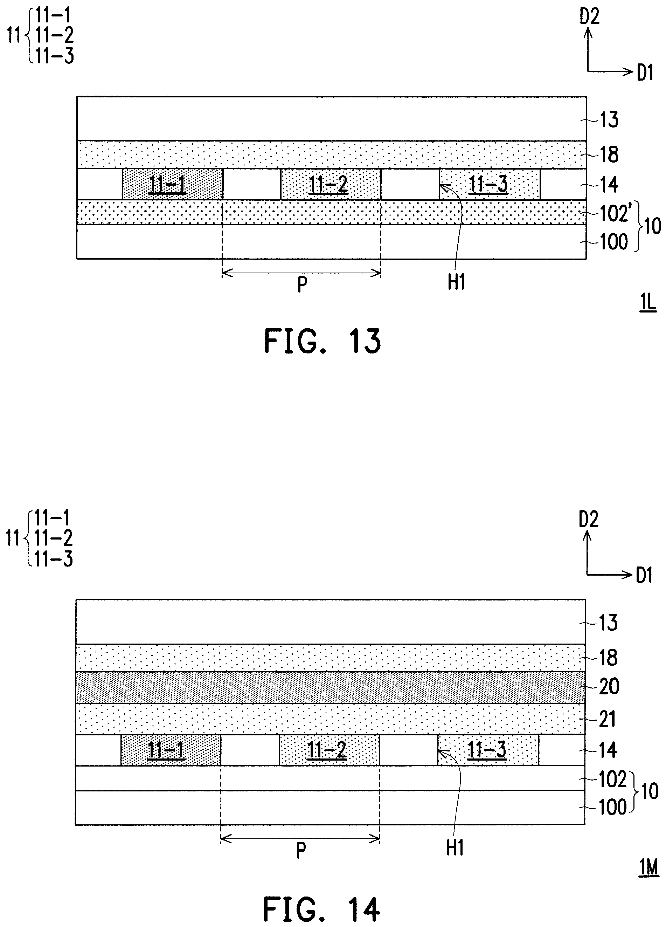

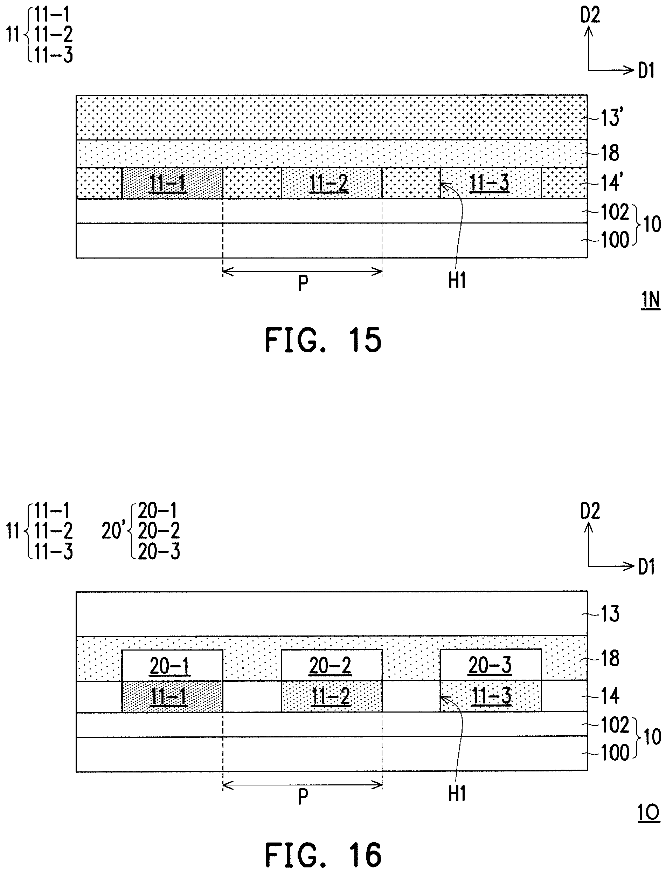

FIG. 1 to FIG. 16 are partial cross-sectional schematic diagrams of display devices according to various embodiments of the present disclosure, respectively.

DESCRIPTION OF EMBODIMENTS

Reference will now be made in detail to the exemplary embodiments of the present disclosure, examples of which are illustrated in the accompanying drawings. Wherever possible, the same reference numbers are used in the drawings and descriptions to refer to the same or like parts.
Certain terms will be used throughout the specification and appended claims of this disclosure to refer to particular elements. Those skilled in the art should understand that electronic device manufacturers may refer to the same component by different names. The text does not intend to distinguish between those elements that have the same function but have different names. In the following description and claims, terms such as "comprising" and "including" are open-ended words, so they should be interpreted as meaning "including but not limited to...".
The directional terms mentioned herein, such as "upper", "lower", "front", "rear", "left", "right", etc., only refer to the directions of the accompanying drawings. Accordingly, the directional terms are used for illustration, not for limitation of the present disclosure. In the drawings, each figure illustrates the general characteristics of methods, structures and/or materials used in particular embodiments. However, these drawings should not be interpreted as defining or limiting the scope or nature encompassed by these embodiments. For example, the relative sizes, thicknesses and positions of layers, regions and/or structures may be reduced or exaggerated for clarity.

A structure (or layer, element, substrate) described in this disclosure is located on/over another structure (or layer, element, substrate), which can mean that the two structures are adjacent and directly connected, or it can mean that the two structures are adjacent rather than directly connected. Indirect connection means that there is at least one intermediate structure (or intermediate layer, intermediate element, intermediate substrate, intermediate space) between two structures, and the lower surface of a structure is adjacent to or directly connected to the upper surface of the intermediate structure. The upper surface of the other structure is adjacent to or directly connected to the lower surface of the intermediate structure. The intermediate structure can be composed of a single layer or multi-layer physical structure or a non-physical structure, the disclosure is not limited thereto. In this disclosure, when a certain structure is set "on" other structures, it may mean that a certain structure is "directly" on other structures, or that a certain structure is "indirectly" on other structures, that is, there is at least one structure interposed between a certain structure and other structures.

The terms "about", "equal to", "equivalent to" or "identical", "substantially" or "generally" are normally interpreted as being within 10% of a given value or range, or as being within 5%, 3%, 2%, 1%, or 0.5% of a given value or range. In addition, the description that "the range is from the first value to the second value" and "the range is between the first value and the second value" mean that the range includes the first value, the second value and other values therebetween.

Ordinal numbers used in the specification and claims, such as "first", "second", etc., are used to modify elements, which neither implies nor means that the (or these) elements are preceded by any ordinal numbers, nor indicates the order of a certain element with another element, or the order of the manufacturing method. The use of these ordinal numbers is only used to clearly distinguish the element with a certain name from another element with the same name. Different terms may be adopted in claims and the specification, accordingly, the first component in the description may be referred to as the second component in the claim.

In this disclosure, the thickness, length and width may be measured by optical microscope (OM), and the thickness or width may be obtained by measuring the cross-sectional image in the electron microscope, but the disclosure is not limited thereto. Additionally, optical microscope and/or electron microscope may be used to observe the structural features in the present disclosure, such as color filter unit, light-absorbing layer, light-absorbing spacer layer, anti-reflection layer or protecting layer with anti-reflection effect, etc.

In addition, any two values or directions used for comparison may have certain errors. In addition, the terms "equal to", "equivalent to", "same", "substantially" or "generally" mentioned in the present disclosure generally mean that a value falls within 10% of a given value or range. Moreover, the phrase "a given range is between a first value and a second value", "a given range falls within a range of a first value to a second value" or "a given range is between a first value and a second value" means that the given range includes the first value, the second value and other values therebetween. If the first direction is perpendicular to the second direction, the angle between the first direction and the second direction can be between 80 degrees and 100 degrees; if the first direction is parallel to the second direction, the angle between the first direction and the second direction may be between 0 degrees and 10 degrees.

It should be noted that, in the following embodiments, without departing from the spirit of the present disclosure, the features in several different embodiments can be replaced, reorganized, and mixed to complete other embodiments. As long as the features of the various embodiments do not violate the spirit of the disclosure or conflict with each other, they can be mixed and matched freely.

Unless otherwise defined, all terms (including technical and scientific terms) used herein have the same meaning as commonly understood by one of ordinary skill in the art to which this disclosure belongs. It can be understood that these terms, such as those defined in commonly used dictionaries, should be interpreted as having meanings consistent with the background or context of the related technology and the present disclosure, and should not be interpreted in an idealized or overly formal manner, unless otherwise specified in the disclosed embodiments.

In the present disclosure, the electronic device may include a display device, a backlight device, an antenna device, a sensing device or a splicing device, but not limited thereto. The electronic device may be a bendable or flexible electronic device. The display device may be a non-self-luminous display device or a self-luminous display device. The electronic device may include, for example, liquid crystal, light-emitting diode, fluorescence, phosphor, quantum dot (QD), other suitable display media, or a combination thereof. The antenna device may be a liquid crystal type antenna device or a non-liquid crystal type antenna device, and the sensing device may be a sensing device for sensing capacitance, light, thermal energy or ultrasonic waves, but not limited thereto. In the present disclosure, an electronic device may include electronic components, and the electronic components may include passive components and active components, such as capacitors, resistors, inductors, diodes, transistors, and the like. The diodes may include light-emitting diodes or photodiodes. The light-emitting diode may include, for example, an organic light emitting diode (OLED), a mini light-emitting diode (mini LED), a micro light-emitting diode (micro LED) or a quantum dot light-emitting diode (quantum dot LED), but not limited thereto. The splicing device may be, for example, a display splicing device or an antenna splicing device, but is not limited thereto. It should be noted that the electronic device can be any permutation and combination of the aforementioned, but not limited thereto. In addition, the shape of the electronic device may be rectangular, circular, polygonal, with curved edges, or other suitable shapes. An electronic device may have peripheral systems such as a drive system, a control system, a light source system, ... to support a display device, an antenna device, a wearable device (such as including augmented reality or virtual reality), a vehicle-mounted device (such as including a car windshield), or a splicing device.

FIG. 1 to FIG. 16 are partial cross-sectional schematic diagrams of display devices according to various embodiments of the present disclosure, respectively. Please refer to FIG. 1, the display device 1 may include a substrate 10, a plurality of light-emitting units 11, a plurality of color filter units 12, and a protecting layer 13. The plurality of light-emitting units 11 are disposed on the substrate 10, and there is a pitch P between two adjacent light-emitting units. The plurality of color filter units 12 are disposed on the plurality of light-emitting units 11 and include a first color filter unit 12-1. The first color filter unit 12-1 overlaps with the first light-emitting unit 11-1 of the plurality of light-emitting units 11. The protecting layer 13 is disposed on the plurality of color filter units 12. The display device 1 has a maximum light-emitting angle θ2, the protecting layer 13 has a refractive index n1, the first color filter unit 12-1 has a width WCF along the first direction D1, and the light-emitting layer (not shown) of the first light-emitting unit 11-1 has a width WL along the first direction D1. The first color filter unit 12-1 has a thickness HCF, and a distance H is formed between the first light-emitting unit 11-1 and the first color filter unit 12-1. The display device satisfies:

$$2 * \tan\left\{\sin^{-1}\left[\frac{\sin(\theta2)}{n1}\right]\right\} * (HCF + H) + WL \leq WCF \leq \frac{1}{2} * P$$

In detail, the substrate 10 may be a printed circuit board, a flexible printed circuit board or a plate on which a circuit is formed, but not limited thereto. For example, the substrate 10 may include a substrate 100 and a circuit layer 102, but not limited thereto. The substrate 100 may be a rigid substrate or a flexible substrate. The material of the substrate 100 includes, for example, glass, quartz, ceramics, sapphire or plastic, but is not limited thereto. Plastics may include polycarbonate (PC), polyimide (PI), polypropylene (PP), polyethylene terephthalate (PET), other suitable flexible material or a combination of the aforementioned materials, but not limited thereto. The circuit layer 102 is disposed on the substrate 100. Although it is not shown, the circuit layer 102 may include a single metal layer (e.g., a patterned metal layer); alternatively, the circuit layer 102 may include multiple metal layers (e.g., a patterned metal layer), multiple insulating layers, and multiple conductive vias (not shown), but not limited thereto. A plurality of metal layers and a plurality of insulating layers are alternately stacked on the substrate 100, and a plurality of conductive vias respectively penetrate through one or more insulating layers to electrically connect two corresponding patterned metal layers (not shown).

A plurality of light-emitting units 11 are disposed on the substrate 10 and electrically connected to the circuit layer 102. For example, the plurality of light-emitting units 11 may include a first light-emitting unit 11-1, a second light-emitting unit 11-2, and a third light- emitting unit 11-3, but not limited thereto. Although FIG. 1 schematically shows one first light-emitting unit 11-1, one second light-emitting unit 11-2, and one third light-emitting unit 11-3, the display device 1 may include a plurality of first light-emitting units 11-1, a plurality of second light-emitting units 11-2 and a plurality of third light-emitting units 11-3.

The first light-emitting unit 11-1, the second light-emitting unit 11-2 and the third light-emitting unit 11-3 may be light-emitting units of the same color or light-emitting units of different colors. For example, the first light-emitting unit 11-1, the second light-emitting unit 11-2 and the third light-emitting unit 11-3 may be respectively a red light-emitting unit, a green light-emitting unit and a blue light-emitting unit, but not limited thereto. Alternatively, the first light-emitting unit 11-1, the second light-emitting unit 11-2 and the third light-emitting unit 11-3 may be a blue light-emitting unit (or an ultraviolet light-emitting unit) combined with various light conversion materials. The light-emitting unit may include, for example, mini light-emitting diodes, micro light-emitting diodes or quantum dot light-emitting diodes, but is not limited thereto. The light conversion material may include, for example, fluorescence, phosphorescence, quantum dots, other suitable light conversion materials, or combinations thereof, but is not limited thereto.

The pitch P of a plurality of light-emitting units 11 refers to the pitch between two adjacent light-emitting units 11, for example, a distance between the edge of the light-emitting unit 11 (such as the light-emitting unit 11-1) and the corresponding edge of the adjacent light-emitting unit 11 (such as the light-emitting unit 11-2), or a distance between the centerline of the light-emitting unit 11 and the centerline of adjacent light-emitting unit 11.

In some embodiments, the display device 1 may further include a spacer layer 14. The spacer layer 14 is, for example, disposed between the first light-emitting unit 11-1 and the second light-emitting unit 11-2 and between the second light-emitting unit 11-2 and the third light-emitting unit 11-3, but not limited thereto. The spacer layer 14 may be a pixel defining layer and has a plurality of openings H1 for respectively accommodating the plurality of light-emitting units 11, and the plurality of light-emitting units 11 are respectively disposed in the plurality of openings H1 of the spacer layer 14. The spacer layer 14 may include, for example, a transparent polymer material, and the transparent polymer material may include resin, but not limited thereto.

A plurality of color filter units 12 are arranged on a plurality of light-emitting units 11 (including first light-emitting unit 11-1, second light-emitting unit 11-2 and third light-emitting unit 11-3). The plurality of color filter units 12 allow light of a specific wavelength to pass through and absorb light of other wavelengths. For example, the plurality of color filter units 12 may include a first color filter unit 12-1, a second color filter unit 12-2, and a third color filter unit 12-3. The first color filter unit 12-1 allows at least part of the light (for example, at least part of red light) from the first light-emitting unit 11-1 to pass through and absorb the rest of the color light, the second color filter unit 12-2 allows at least part of the light (such as at least part of green light) from the second light-emitting unit 11-2 to pass through and absorbs the rest of the color light, and the third color filter unit 12-3 allows at least part of the light (such as at least part of blue light) from the third light-emitting unit 11-3 to pass through and absorbs the rest of color right, but not limited thereto. Although FIG. 1 schematically shows a first color filter unit 12-1, a second color filter unit 12-2, and a third color filter unit 12-3, the display device 1 may include a plurality of first color filter units 12-1, a plurality of second color filter units 12-2, and a plurality of third color filter units 12-3.

The first color filter unit 12-1, the second color filter unit 12-2 and the third color filter unit 12-3 respectively correspond to the first light-emitting unit 11-1, the second light-emitting unit 11-2 and the third light-emitting unit 11-3. For example, the first color filter unit 12-1, the second color filter unit 12-2 and the third color filter unit 12-3 are respectively overlapped with the first light-emitting unit 11-1, the second light-emitting unit 11-2 and the third light-emitting unit 11-3 in the normal direction (such as the second direction D2) of the substrate 10.

In some embodiments, a plurality of color filter units 12 may be attached to a plurality of light-emitting units 11 and the spacer layer 14 through an adhesive layer (such as an adhesive layer 17). Taking FIG. 1 as an example, the display device 1 may further include a substrate 15, a light-shielding layer 16, and an adhesive layer 17. The substrate 15 is opposite to the substrate 10, and the material of the substrate 15 may refer to the material of the substrate 100, which will not be repeated here. The light-shielding layer 16 is disposed on the surface of the substrate 15 facing the substrate 10 and has a plurality of openings H2 respectively overlapping with the plurality of light-emitting units 11, and the plurality of color filter units 12 are respectively disposed in the plurality of openings H2. The light-shielding layer 16 may include a light-shielding material (such as a light-absorbing material), and the light-absorbing material may include a black matrix, but not limited thereto. The light-shielding layer 15 and the plurality of color filter units 12 may be attached onto the plurality of light-emitting units 11 and the spacer layer 14 through the adhesive layer 17. The material of the adhesive layer 17 may include optical clear adhesive (OCA) or optical clear resin (OCR), but not limited thereto.

The first color filter unit 12-1, the second color filter unit 12-2 and the third color filter unit 12-3 may be used to control the wavelength range of the light B emitted from the display device 1, which helps to enhance color purity. On the other hand, part of the ambient light incident onto the display device 1 is absorbed by the first color filter unit 12-1, the second color filter unit 12-2, the third color filter unit 12-3 and/or the light-shielding layer 16, thereby reducing the intensity of ambient light reflected by the display device 1, and thus helping to reduce the reflectivity of the display device 1 or improve the contrast of the display device 1.

The protecting layer 13 is disposed on the substrate 15. For example, the display device 1 may further include an adhesive layer 18, and the protecting layer 13 may be attached onto the substrate 15 through the adhesive layer 18. The materials of the protecting layer 13 and the adhesive layer 18 may refer to the materials of the substrate 100 and the adhesive layer 17 respectively, and will not be repeated here.

The maximum light-emitting angle $\theta2$ of the display device 1 is defined as the angle between the viewing angle corresponding to zero brightness and the normal viewing angle, that is, the brightness measured by the brightness receiver at the maximum light-emitting angle $\theta2$ is 0. The degree of the maximum light-emitting angle $\theta2$ will vary according to different product requirements (viewing angle). The refractive index n of the protecting layer 13 varies according to the material selected for the protecting layer 13. For example, when the material of the protecting layer 13 is glass, the refractive index n is 1.5, but not limited thereto. The width WFC of the first color filter unit 12-1 is defined as the width of the top surface of the first color filter unit 12-1 in the first direction D1, and the top surface of the first color filter unit 12-1 is a surface adjacent to the light-emitting side of the display device 1. The thickness HCF of the first color filter unit 12-1 is defined as the maximum thickness of the first color filter unit 12-1 in the second direction D2. The distance H is defined as the minimum distance between the first light-emitting unit 11-1 and the first color filter unit 12-1 in the second direction D2. In some embodiments, since the adhesive layer 17 is adhered to the first light-emitting unit 11-1 and the first color filter unit 12-1, the distance H may be substantially the same as the minimum thickness between the first light-emitting unit 11-1 and the first color filter unit 12-1 in the second direction D2.

According to Snell's law, n1*sin($\theta1$)=n2*sin($\theta2$), in FIG. 1, the light transmission medium on the protecting layer 13 is air, and the refractive index of air is 1, therefore, n2=1, by substituting the above values into the above formula, the formula (1) may be obtained as follows:

$$\theta1 = \sin^{-1}\left[\frac{\sin(\theta2)}{n1}\right] \quad \text{Formula (1)}$$

In addition, according to FIG. 1, formula (2) may be obtained as follows:

$$\tan\theta 1 = \frac{1}{2} * (WCF - WL)/(HCF + H)$$

Formula (2)

The minimum value of WCF may be obtained by substituting formula (1) into formula (2), as shown in formula (3). When the WCF is greater than or equal to the minimum value, the ratio of the light B from the first light-emitting unit 11-1 absorbed by the light-shielding layer 15 may be reduced, thereby maintaining the light extraction efficiency. In addition, according to FIG. 1, the maximum value of WCF is half of the pitch P of the light-emitting unit 11, and WCF may be greater than or equal to WL. Based on the above, formula (4) may be obtained.

$$WCF = 2 * \tan\{\sin^{-1}[\frac{\sin(\theta 2)}{n1}]\} * (HCF + H) + WL$$

Formula (3)

$$2 * \tan\{\sin^{-1}[\frac{\sin(\theta 2)}{n1}]\} * (HCF + H) + WL \leq WCF \leq \frac{1}{2} * P$$

Formula (4)

Through the design of formula (4) and the setting of multiple color filter units, the ambient light reflected by the display device 1 may be reduced while maintaining the light extraction efficiency, thereby helping to improve the contrast of the display device 1.

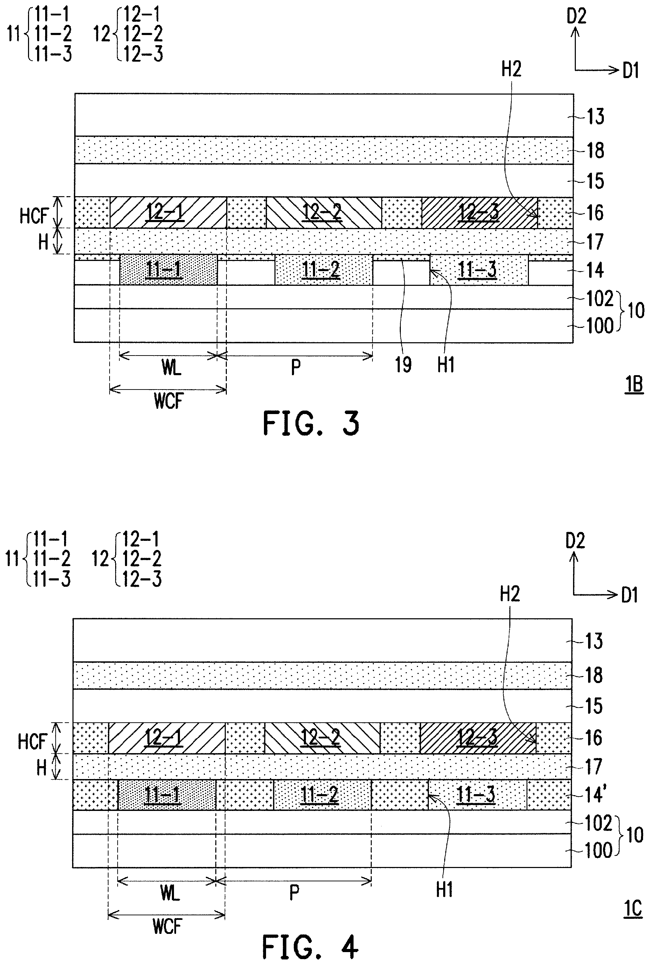

Referring to FIG. 2 (or FIG. 3), the main differences between the display device 1A (or display device 1B) and the display device 1 in FIG. 1 are described as follows. The display device 1A (or the display device 1B) further includes a light-absorbing layer 19 to further reduce the reflectivity of the display device 1. The light-absorbing layer 19 is disposed on an area of the substrate 10 not covered by the plurality of light-emitting units 11 (including a first light-emitting unit 11-1, a second light-emitting unit 11-2 and a third light-emitting unit 11-3). In some embodiments, as shown in FIG. 2, the light-absorbing layer 19 may be disposed below the spacer layer 14. In other embodiments, as shown in FIG. 3, the light-absorbing layer 19 may be disposed above the spacer layer 14. The light-absorbing layer 19 may include light-absorbing materials, and the light-absorbing materials may include chromium, chromium oxide, graphite, poly-vinyl alcohol (PVA), resin, other suitable materials, or combinations thereof. In some embodiments, the light-absorbing layer 19 may include a black matrix, but not limited thereto. In some embodiments, the light-absorbing layer 19 may include a black oxide layer formed by chemically oxidizing the surface of the metal layer (not shown). The material of the metal layer may include molybdenum or its alloys, such as molybdenum-tantalum (MoTa), molybdenum-niobium (MoNb), etc., but not limited thereto.

Referring to FIG. 4, the main differences between the display device 1C and the display device 1 in FIG. 1 are described as follows. In the display device 1C, the spacer layer 14' includes, for example, a light-absorbing material to further reduce the reflectivity of the display device 1. The light-absorbing material may be referred to above, and will not be repeated here.

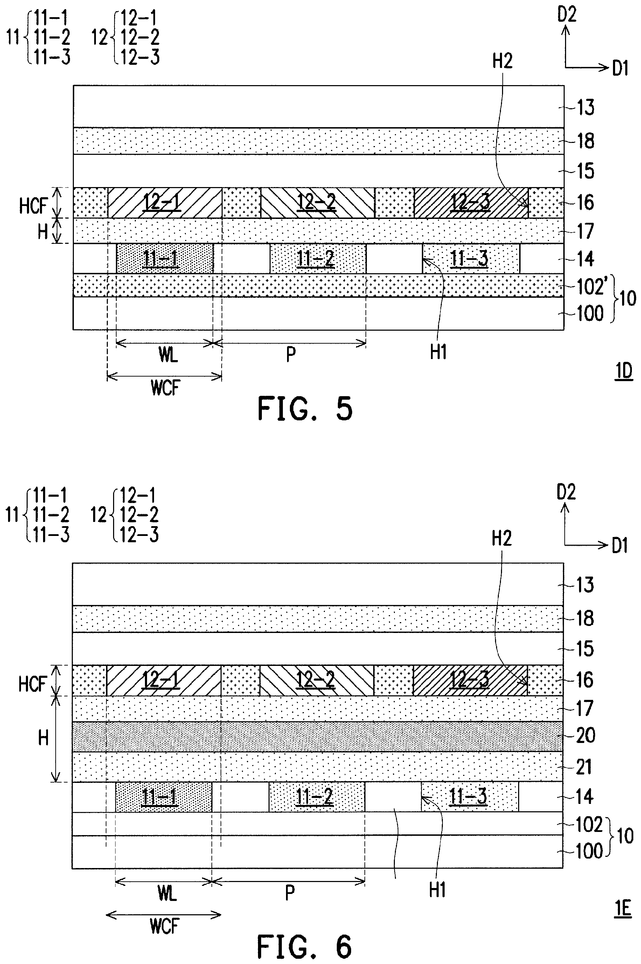

Referring to FIG. 5, the main differences between the display device 1D and the display device 1 in FIG. 1 are described as follows. In the display device 1D, an anti-reflection layer is formed on the surface of the circuit layer 102'. For example, the surface of the top metal layer of the circuit layer 102' may be chemically oxidized so that the surface is formed as a high absorption or low reflection oxide layer. The material of the metal layer may include stainless steel, molybdenum or molybdenum alloys, such as molybdenum-tantalum (MoTa), molybdenum-niobium (MoNb), etc., but not limited thereto. For example, the circuit layer 102' may include stainless steel (or molybdenum, molybdenum alloy) whose surface has been oxidized, and a black oxide layer is formed on the surface of the stainless steel (or molybdenum, molybdenum alloy), which facilitates absorption of ambient light or may reduce reflection of ambient light.

Referring to FIG. 6, the main differences between the display device 1E and the display device 1 in FIG. 1 are described as follows. The display device 1E further includes an anti-reflection layer 20 and an adhesive layer 21. The anti-reflection layer 20 is disposed between the multiple light-emitting units 11 and the multiple color filter units 12. For example, the anti-reflection layer 20 may be attached onto a plurality of light-emitting units 11 and the spacer layer 14 through the adhesive layer 21, and the plurality of color filter units 12 and the light-shielding layer 16 may be attached onto the anti-reflection layer 20 through the adhesive layer 17. The anti-reflection layer 20 may be, for example, a scattering layer or a light-absorbing layer, and the scattering layer or the light-absorbing layer is, for example, continuously disposed on a plurality of light-emitting units 11. Although it is not shown, the scattering layer may include an encapsulation layer and a plurality of scattering particles disposed in the encapsulation layer, and the light-absorbing layer may include an encapsulation layer and a plurality of light-absorbing particles disposed in the encapsulation layer. The material of the encapsulation layer may include polymer material, but is not limited thereto. The scattering particles may include metal particles, white particles or other materials capable of scattering light to reduce the intensity of transmitted light. The light-absorbing particles may include black particles or other materials capable of absorbing light to reduce the intensity of transmitted light. The material of the adhesive layer 21 may refer to the material of the adhesive layer 17, which will not be repeated here.

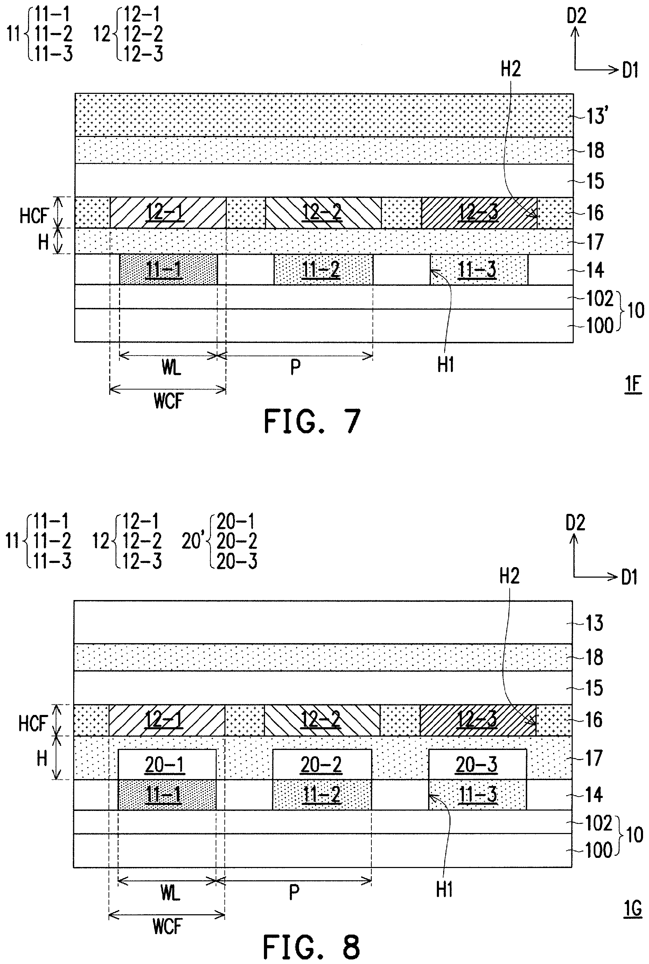

Referring to FIG. 7, the main differences between the display device 1F and the display device 1 in FIG. 1 are described as follows. In the display device 1F, the protecting layer 13' is a protecting layer having an anti-reflection effect. For example, the surface of the protecting layer 13' (such as the surface facing the substrate 10) may be formed (by spraying, for example) with scattering particles or light-absorbing particles to reduce the intensity of transmitted light, but not limited thereto.

Referring to FIG. 8, the main differences between the display device 1G and the display device 1 in FIG. 1 are described as follows. The display device 1G further includes an anti-reflection layer 20', and the anti-reflection layer 20' is disposed on a plurality of light-emitting units 11. For example, the anti-reflection layer 20' includes a plurality of sub-layers (such as sub-layer 20-1, sub-layer 20-2, sub-layer 20-3), and the sub-layer 20-1, sub-layer 20-2, sub-layer 20-3 are respectively disposed on the first light-emitting unit 11-1, the second light-emitting unit 11-2 and the third light-emitting unit 11-3. For example, sub-layers (such as sub-layer 20-1, sub-layer 20-2, and sub-layer 20-3) may be formed on light-emitting units (such as first light-emitting unit 11-1, second light-emitting unit 11-2, third light-emitting unit 11-3) through coating. Although it is not shown, the sub-layers may include, for example, multiple alternating stacked layers of high and low refractive indices to reduce ambient light reflected by the light-emitting units through destructive interference. The parameters of the sub-layer 20-1, the sub-layer 20-2, and the sub-layer 20-3 may be designed according to the wavelength of the corresponding light-emitting unit (such as refractive index, thickness, number of layers, etc.). When the optical layer on the light-emitting unit is observed with an optical microscope or electron microscope, the reflectivity of the light-emitting unit may be measured with the optical layer on the light-emitting unit, and then the optical layer is removed from the light-emitting unit to measure the reflectivity of the light-emitting unit. If the reflectivity measured later is higher than the previously measured reflectivity, it means that the optical layer has an anti-reflection effect, and it can be inferred that the optical layer is a sub-layer disclosed in this disclosure.

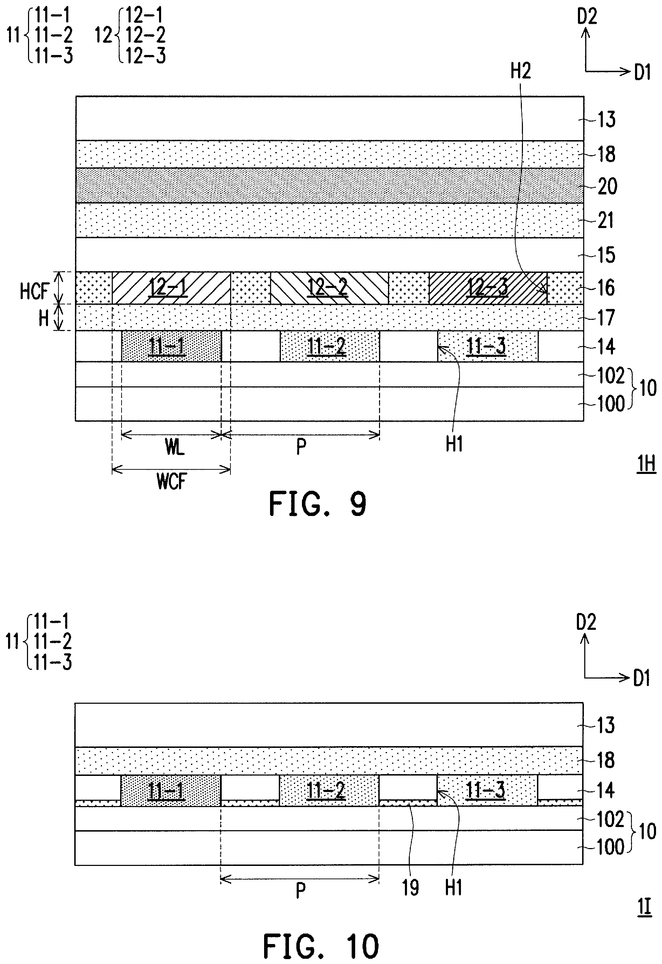

Please refer to FIG. 9, the main difference between the display device 1H and the display device 1E in FIG. 6 is the setting positions of the anti-reflection layer 20 and the adhesive layer 21. In FIG. 6, the adhesive layer 21 and the anti-reflection layer 20 are stacked sequentially between a plurality of light-emitting units 11 and the adhesive layer 17. In FIG. 9, the adhesive layer 21 and the anti-reflection layer 20 are sequentially stacked between the substrate 15 and the adhesive layer 18.

Referring to FIG. 10 to FIG. 16, the main difference between the display device 1I to the display device 1O and the display device 1A to the display device 1G in FIG. 2 to FIG. 8 is that the display device 1I to the display device 1O do not include the above-mentioned multiple color filter units 12, the substrate 15, the light-shielding layer 16 and the adhesive layer 17. The display device 1I to the display device 1O, for example, reduce the reflectivity or improve the contrast of the display device through the light-absorbing layer 19, the spacer layer 14', the circuit layer 102', the anti-reflection layer 20, the protecting layer 13' or the anti-reflection layer 20'.

To sum up, in the embodiment of the present disclosure, the design of formula (4) combined with the setting of multiple color filter units may reduce the ambient light reflected by the display device while maintaining the light extraction efficiency, thus helping to improve the contrast of the display device.

Although the embodiments of the disclosure and their advantages have been disclosed above, it should be understood that any person with ordinary knowledge in the technical field may make changes, substitutions and retouching without departing from the spirit and scope of the disclosure, and the features of various embodiments can be freely mixed and replaced to form other new embodiments. In addition, the protection scope of the present disclosure is not limited to the process, machine, manufacture, material composition, device, method and steps in the specific embodiments described in the specification. Anyone with ordinary knowledge in the technical field can understand that the current or future developed processes, machines, manufacturing, material compositions, devices, methods and steps from the content of this disclosure may be used according to the disclosure as long as they can be implemented in the embodiments described herein with same function or achieving substantially the same result. Therefore, the protection scope of the present disclosure includes the above-mentioned process, machine, manufacture, composition of matter, device, method and steps. In addition, each claim constitutes an individual embodiment, and the protection scope of the present disclosure also includes combinations of the individual claims and the embodiments. The scope of protection of this disclosure should be defined by the appended claims.

**Claims**

1. A display device (1, 1A, 1B, 1C, 1D, 1E, 1F, 1G, 1H), comprising:

   a substrate (10);
   a plurality of light-emitting units (11) disposed on the substrate (10), wherein a pitch P is formed between two of the adjacent light-emitting units (11);
   a plurality of color filter units (12) disposed on the plurality of light-emitting units (11) and comprise a first color filter unit (12-1), wherein the first color filter unit (12-1) is overlapped with a first light-emitting unit (11-1) of the plurality of light-emitting units (11); and
   a protecting layer (13, 13') disposed on the plurality of color filter units (12),
   wherein the display device (1, 1A, 1B, 1C, 1D, 1E, 1F, 1G, 1H) has a maximum light-emitting angle θ2, the protecting layer (13, 13') has a refractive index n1, the first color filter unit (12-1) has a width WCF along a first direction (D1), a light-emitting layer of the first light-emitting unit (11-1) has a width WL along the first direction (D1), and the first color filter unit (12-1) has a thickness HCF, a distance H is formed between the first light-emitting unit (11-1) and the first color filter unit (12-1), and the display device (1, 1A, 1B, 1C, 1D, 1E, 1F, 1G, 1H) satisfies:

$$2 * \tan\{\sin^{-1}[\frac{\sin(\theta 2)}{n1}]\} * (HCF + H) + WL \leq WCF \leq \frac{1}{2} * P$$

.

2. The display device (1A, 1B) according to claim 1, wherein the plurality of light-emitting units (11) further comprise a second light-emitting unit (11-2), and the display device (1A, 1B) further comprises:
   a light-absorbing layer (19) disposed on an area of the substrate (10) not covered by the first light-emitting unit (11-1) and the second light-emitting unit (11-2).

3. The display device (1B) according to claim 2, further comprising:
   a spacer layer (14) disposed between the first light-emitting unit (11-1) and the second light-emitting unit (11-2), and the light-absorbing layer (19) is disposed above the spacer layer (14).

4. The display device (1A) according to claim 2, further comprising:
   a spacer layer (14) disposed between the first light-emitting unit (11-1) and the second light-emitting unit (11-2), and the light-absorbing layer (19) is disposed below the spacer layer (14).

5. The display device (1D) according to claim 1, wherein the substrate (10) comprises a circuit layer (102'), the circuit layer (102') is electrically connected to the plurality of light-emitting units (11), and a surface of the circuit layer (102') forms an anti-reflection layer.

6. The display device (1E, 1G) according to claim 1, further comprising:
   an anti-reflection layer (20, 20') disposed between the plurality of light-emitting units (11) and the plurality of color filter units (12) or on the plurality of light-emitting units (11).

7. The display device (1E) according to claim 6, wherein the anti-reflection layer (20) is a scattering layer, and the scattering layer is continuously disposed on the plurality of light-emitting units (11).

8. The display device (1E) according to claim 7, wherein the scattering layer comprises an encapsulation layer and a plurality of scattering particles disposed in the encapsulation layer.

9. The display device (1E) according to claim 6, wherein the anti-reflection layer (20) is a light-absorbing layer, and the light-absorbing layer is continuously disposed on the plurality of light-emitting units (11).

10. The display device (1E) according to claim 9, wherein the light-absorbing layer comprises an encapsulation layer and a plurality of light-absorbing particles disposed in the encapsulation layer.

11. The display device (1G) according to claim 6, wherein the plurality of light-emitting units (11) further comprise a second light-emitting unit (11-2), and the anti-reflection layer (20') comprises a plurality of sub-layers (20-1, 20-2), and the plurality of sub-layers (20-1, 20-2) are respectively disposed on the first light-emitting unit (11-1) and the second light-emitting unit (11-2).

12. The display device (1G) according to claim 11, wherein a thickness of each of the plurality of sub-layers (20-1, 20-2) is less than the distance H.

13. The display device (1C) according to claim 1, further comprising:
a spacer layer (14') disposed between the plurality of light-emitting units (11), and the spacer layer (14') is formed of a light-absorbing material.

14. The display device (1, 1A, 1B, 1C, 1D, 1E, 1F, 1G, 1H) according to claim 1, further comprising:
an adhesive layer (17) disposed between the plurality of light-emitting units (11) and the plurality of color filter units (12).

15. The display device (1, 1A, 1B, 1C, 1D, 1F, 1G, 1H) according to claim 14, wherein a thickness of the adhesive layer (17) is equal to the distance H.

$11\begin{cases} 11\text{-}1 \\ 11\text{-}2 \\ 11\text{-}3 \end{cases}$  $12\begin{cases} 12\text{-}1 \\ 12\text{-}2 \\ 12\text{-}3 \end{cases}$

**FIG. 1**

$11\begin{cases} 11\text{-}1 \\ 11\text{-}2 \\ 11\text{-}3 \end{cases}$  $12\begin{cases} 12\text{-}1 \\ 12\text{-}2 \\ 12\text{-}3 \end{cases}$

**FIG. 2**

$11\begin{cases}11\text{-}1\\11\text{-}2\\11\text{-}3\end{cases}$  $12\begin{cases}12\text{-}1\\12\text{-}2\\12\text{-}3\end{cases}$

D2

D1

H2

HCF

H

WL

P

19 H1

WCF

13
18
15
16
17
14
102
100
10

1B

FIG. 3

$11\begin{cases}11\text{-}1\\11\text{-}2\\11\text{-}3\end{cases}$  $12\begin{cases}12\text{-}1\\12\text{-}2\\12\text{-}3\end{cases}$

D2

D1

H2

HCF

H

WL

P

H1

WCF

13
18
15
16
17
14'
102
100
10

1C

FIG. 4

$11\begin{cases} 11\text{-}1 \\ 11\text{-}2 \\ 11\text{-}3 \end{cases}$ $12\begin{cases} 12\text{-}1 \\ 12\text{-}2 \\ 12\text{-}3 \end{cases}$

D2
→D1

H2

HCF
H

12-1    12-2    12-3    —16
—17
11-1    11-2    11-3    —14

—13
—18
—15

—102'
—100    }10

WL    P    H1
WCF

1D

**FIG. 5**

$11\begin{cases} 11\text{-}1 \\ 11\text{-}2 \\ 11\text{-}3 \end{cases}$ $12\begin{cases} 12\text{-}1 \\ 12\text{-}2 \\ 12\text{-}3 \end{cases}$

D2
→D1

H2

HCF

H

12-1    12-2    12-3    —16
—17

—20
—21

11-1    11-2    11-3    —14

—13
—18
—15

—102
—100    }10

WL    P    H1
WCF

1E

**FIG. 6**

$11\begin{cases}11\text{-}1\\11\text{-}2\\11\text{-}3\end{cases}$ $12\begin{cases}12\text{-}1\\12\text{-}2\\12\text{-}3\end{cases}$

FIG. 7

$11\begin{cases}11\text{-}1\\11\text{-}2\\11\text{-}3\end{cases}$ $12\begin{cases}12\text{-}1\\12\text{-}2\\12\text{-}3\end{cases}$ $20'\begin{cases}20\text{-}1\\20\text{-}2\\20\text{-}3\end{cases}$

FIG. 8

$11\begin{cases} 11\text{-}1 \\ 11\text{-}2 \\ 11\text{-}3 \end{cases}$  $12\begin{cases} 12\text{-}1 \\ 12\text{-}2 \\ 12\text{-}3 \end{cases}$

D2
↑
→ D1

— 13
— 18
— 20
— 21
— 15

HCF
H

12-1    12-2    12-3    H2 — 16
— 17

11-1    11-2    11-3 — 14
— 102
— 100 } 10

WL    P    H1

WCF

1H

**FIG. 9**

$11\begin{cases} 11\text{-}1 \\ 11\text{-}2 \\ 11\text{-}3 \end{cases}$

D2
↑
→ D1

— 13
— 18

11-1    11-2    11-3 — 14
— 102
— 100 } 10

P    19   H1

1I

**FIG. 10**

$11\begin{cases} 11-1 \\ 11-2 \\ 11-3 \end{cases}$

D2
D1

13
18
11-1  11-2  11-3  14
102  10
100

P  19  H1

1J

# FIG. 11

$11\begin{cases} 11-1 \\ 11-2 \\ 11-3 \end{cases}$

D2
D1

13
18
11-1  11-2  11-3  14'
102  10
100

P  H1

1K

# FIG. 12

FIG. 13

FIG. 14

$11\begin{cases}11-1\\11-2\\11-3\end{cases}$

D2 → D1

13'
18
11-1  11-2  11-3  14'
102
100 } 10

P

H1

1N

# FIG. 15

$11\begin{cases}11-1\\11-2\\11-3\end{cases}$   $20'\begin{cases}20-1\\20-2\\20-3\end{cases}$

D2 → D1

13
18
20-1  20-2  20-3
11-1  11-2  11-3  14
102
100 } 10

P

H1

10

# FIG. 16

Europäisches
Patentamt

European
Patent Office

Office européen
des brevets

# EUROPEAN SEARCH REPORT

Application Number

**EP 23 17 4309**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | WO 2021/152418 A1 (SEMICONDUCTOR ENERGY LAB [JP]) 5 August 2021 (2021-08-05) * paragraphs [0033], [0074], [0076]; figure 4 * | | INV. H10K59/38 H10K59/35 H10K59/121 |
| X | JP 2021 161401 A (TORAY INDUSTRIES) 11 October 2021 (2021-10-11) * paragraphs [0315], [0317], [0319]; figures 9,7,3; example 42 * | 1-15 | |
| X | US 2014/062294 A1 (TOYODA HIRONORI [JP] ET AL) 6 March 2014 (2014-03-06) * paragraph [0007]; claim 1; figure 2 * | 1 | |
| A | JP 2013 152853 A (CANON KK) 8 August 2013 (2013-08-08) * paragraph [0085]; figure 2; example 1 * | 1-15 | |

TECHNICAL FIELDS
SEARCHED (IPC)

H10K

The present search report has been drawn up for all claims

| Place of search | Date of completion of the search | Examiner |
|---|---|---|
| The Hague | 9 October 2023 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 17 4309**

This annex lists the patent family members relating to the patent documents cited in the above-mentioned European search report.
The members are as contained in the European Patent Office EDP file on
The European Patent Office is in no way liable for these particulars which are merely given for the purpose of information.

**09-10-2023**

| Patent document cited in search report | | Publication date | Patent family member(s) | | Publication date |
|---|---|---|---|---|---|
| WO 2021152418 | A1 | 05-08-2021 | CN | 114982377 A | 30-08-2022 |
| | | | JP | WO2021152418 A1 | 05-08-2021 |
| | | | KR | 20220133229 A | 04-10-2022 |
| | | | TW | 202131536 A | 16-08-2021 |
| | | | US | 2023117024 A1 | 20-04-2023 |
| | | | WO | 2021152418 A1 | 05-08-2021 |
| JP 2021161401 | A | 11-10-2021 | NONE | | |
| US 2014062294 | A1 | 06-03-2014 | CN | 103681757 A | 26-03-2014 |
| | | | JP | 2014049313 A | 17-03-2014 |
| | | | KR | 20140029238 A | 10-03-2014 |
| | | | TW | 201413941 A | 01-04-2014 |
| | | | US | 2014062294 A1 | 06-03-2014 |
| JP 2013152853 | A | 08-08-2013 | NONE | | |

EPO FORM P0459

For more details about this annex : see Official Journal of the European Patent Office, No. 12/82